(19) Europäisches Patentamt / European Patent Office / Office européen des brevets

(11) **EP 3 712 640 A1**

(12) **EUROPEAN PATENT APPLICATION**

(43) Date of publication:
**23.09.2020 Bulletin 2020/39**

(51) Int Cl.:
*G01S 7/02* (2006.01)          *H01Q 1/40* (2006.01)
*H01Q 23/00* (2006.01)          *H01L 23/00* (2006.01)

(21) Application number: **19163801.4**

(22) Date of filing: **19.03.2019**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Silicon Radar GmbH**
**15236 Frankfurt (Oder) (DE)**

(72) Inventor: **WINKLER, Wolfgang**
**15234 Frankfurt (Oder) (DE)**

(74) Representative: **Maiwald Patent- und Rechtsanwaltsgesellschaft mbH**
**Elisenhof**
**Elisenstraße 3**
**80335 München (DE)**

Remarks:
Amended claims in accordance with Rule 137(2) EPC.

(54) **RADAR SENSOR IN TRANSPARENT PACKAGE**

(57) The invention relates to a radar circuit package (21) for protecting a radar circuit (20) and for effective radiation of a radar signal. The radar circuit package comprises a radar circuit (20) with an antenna (26), a dielectric cover (22), on which the radar circuit (20) is mounted, a lead frame (23), configured to be electronically connected to the radar circuit (20) by means of at least one electric connection (25) and a dielectric filling (24), which is configured to cover the radar circuit (20), the at least one electric connection (25) and at least one part of the lead frame (23). The dielectric cover (22) and the dielectric filling are configured to protect the radar circuit (20). The invention further relates to a sensor (100) comprising a radar circuit package (21) and a method for fabricating a radar circuit package (21).

Fig. 2

## Description

Field of the invention

The present invention relates to the field of semiconductor packaging technology for integrated circuits for radar and/or communication applications. Particularly, the invention relates to a radar circuit package for protecting a radar circuit and for effective radiation of a radar signal, a sensor comprising a radar circuit package and a method for fabricating a radar circuit package.

Background

With the continuing development of the wireless electronic industry towards miniaturization, high performance and low cost, packaging technology becomes a decisive or limiting factor for fabricating a sensor with an integrated circuit (IC) or with a chip. The packaging approach is required to provide both mechanical support and electrical connection with various microwave or millimeter-wave (MMW) or even Terahertz components, including such as RFIC (Radio Frequency Integrated Circuits) chips, high-efficiency antennas, transmission lines, capacitors, inductors, resistors, MEMS devices, and various types of filters. For example, a RFIC (radio frequency integrated circuit) chip may be fabricated using semiconductor technology with Si, GaAs, CMOS (complementary metal-oxide-semiconductor) or SiGe. The chip is usually encapsulated within a semiconductor package to ensure reliable and low-cost PCB (printed circuit board)-assembly during production process.

Various packaging technologies are applied depending on the operating signals of the chips at different frequencies.

Packaging technology, such as the low-cost QFN (Quad Flat No Lead) package, is applicable as a conventional packaging method for low frequency bands, e.g. 24 GHz ISM-band. Accordingly, bonding technology or wire bonding technology, which couples electromagnetic energy from the chip to an off-chip antenna disposed on a PCB, is extensively used to build relative low-frequency connections (below 25 GHz).

The wire bonding technology may often limit the bandwidth of the operating signal. The typical diameter of the gold wires used in such wire bonding technology is about 25 $\mu$m. These stand-alone wires provide a parasitic inductance of about 1 nH/mm which introduces a large mismatch with MMW at high frequencies. To resonate out the inductance of these wires and to carry a high frequency signal, it is necessary to place a ground wire adjacent to the signal wire with a certain distance, aiming to maintain a good impedance match to the antenna. The arrangement of such a wire requires an accurate control of the wire bonding profile, which may significantly increase the packaging cost in high-volume production. Alternatively, flip-chip packaging technology is utilized with a smaller parasitic inductance. In the flip-chip technology, the silicon die is flipped on top of a PCB and gold or solder bumps are used to connect the PCB antenna via transmission line. However, fine-line technology on the PCB as well as the high-performance and low dielectric loss of the PCB-material are required to ensure sufficient antenna performance. Besides the high cost, it is also challenging to reach a wide bandwidth with the flip-chip technique.

For high frequency approaches, the package may contain one or more semiconductor integrated circuits or radar chips with an integrated antenna or integrated antennas. For an extremely high frequency (EHF) in millimeter wave MMW range, such as 77 GHz, packaging technology such as eWLB (embedded wafer level ball-grid array) is applied for a long-range automotive radar in SiGe or RF-CMOS technology. At a tremendously high frequency (THF) in submillimetre wave range, such as at terahertz (THz) frequencies with wide bandwidth, advanced packaging technology may be required to produce a sensor with an efficient radar circuit or radar chip, which comprises an integrated on-chip antenna, in a reliable or reproducible way.

Summary

It may be seen as an objective of the invention to provide a robust packaging solution for a compact radar circuit.

The objective is achieved by the subject matter of the independent claims. The dependent claims, the following description and the drawings show embodiments of the invention.

According to a first aspect, a radar circuit package for protecting a radar circuit or a radar chip or a circuit package and for effective radiation of a radar signal is provided. The radar circuit package comprises a radar circuit, a dielectric cover, on which the radar circuit is mounted, a lead frame and a dielectric filling.

The radar circuit comprises an integrated antenna and may operate in the millimeter to submillimeter wave range. In other words, the radar circuit is configured to transmit and receive electromagnetic signals with a high frequency ranging from 30 GHz to THz-range.

The radar circuit further comprises at least an electrical pad, which is configured to be electrically connected to other components of the radar circuit, in particular the lead frame.

The dielectric cover, on which the radar circuit with the integrated antenna is mounted or attached, is configured to protect the radar circuit. In particular, the radar circuit may be glued to the dielectric cover using a non-conducting glue, which has good thermal conductivity.

The dielectric cover may comprise silicon, aluminium nitride (AIN) or CVD-diamond (chemical vapour deposited synthetic diamond) with a relative dielectric constant of 11.9, 10 or 5.7, respectively. Preferred material for the cover for packaging of Silicon-based chips is Silicon because of the good matching of dielectric and thermal coefficients. The dielectric cover may be in form of a plate. Such a dielectric plate may facilitate the packaging of the radar chip in automated series production.

The dielectric cover may be directly attached or mounted to the lead frame.

The lead frame is configured to be electrically connected to the radar circuit by means of at least one electric connection.

For example, the lead frame comprises or consists of copper for optimized electrical conductivity and thermal conductivity at a reasonable cost. On the bottom side of the lead frame or on the side opposite to the dielectric cover, at least one solder pin is formed or arranged, which is configured to connect the lead frame to the PCB.

The electric connection may be in form of a bond wire, which can be wire-bonded with ultrasonic energy to the lead frame at one end and to the electrical pad of the radar circuit at the other end. Alternatively, the electric connection may be generated by additive manufacturing, which may further improve the packaging process of the radar circuit or by flip-chip technologies.

The lead frame may connect the radar circuit by means of the at least one electric connection, which is connected to the electrical pad of the radar circuit, to the at least one solder pin of the radar circuit package, which is configured to connect the radar circuit package to the PCB.

The dielectric filling or a moulding compound is provided and configured to cover the radar circuit, the at least one electric connection and the at least one part of the lead frame. The dielectric filling may comprise a resin or an epoxy resin, which is able to stabilize all of the components including the antenna of the radar circuit, the electric connections between the radar circuit and the at least one part of the lead frame, and other vulnerable parts of the radar circuit package. As such, the dielectric filling is configured to protect the radar circuit.

The dielectric cover is configured to be transparent for the radiation. In other words, the radiation of interest, which is transmitted or received by the radiating circuit, is able to pass through the dielectric cover with minimal energy loss.

According to a first embodiment, the radar circuit package may further comprise a dielectric lens, which is arranged on top of the dielectric cover.

For high antenna-efficiency and for a wide bandwidth of the operating signal, the radiation of the radar circuit is directed through the dielectric lens. The dielectric lens may comprise or consist of un-doped silicon or other non-conducting materials with a relative dielectric constant or a relative permittivity similar to silicon ($\varepsilon_r$=11.9). Alternatively, the lens may comprise or consist of plastic material to reduce cost. In this case, the relative dielectric constant may be in the range from 12 to 6 for optimized performance.

To alleviate the coupling problem and thus to optimize the radiation transition from the lens surface to the environment or air, the lens may comprise a matching layer at the top with dielectric constant between that of the lens material and that of air.

Furthermore, the radar circuit package is able to be applied in a radar apparatus or a radar system with flexible shape and size of the lens.

According to a second embodiment, the dielectric cover is configured to distribute heat generated by the radar circuit to the lead frame, which, in turn, is configured to distribute the heat to the at least one solder pin or solder pins.

According to another embodiment, the dielectric cover may comprise silicon, aluminium nitride (AIN) or diamond.

According to another embodiment, the dielectric cover may comprise crystalline silicon, and in particular mono-crystalline silicon.

The thermal conductivity from the radiating device to the environment is an important parameter for the package performance, as most of thermal energy, generated in the radiating device, needs to be dissipated or is transferred to the PCB, on which the radar circuit package is mounted. In other words, the heat generated by the radar circuit needs to be distributed. The materials of silicon, aluminium nitride (AIN) and diamond are well-known in semiconductor industry and are available in high quality, at low cost and with thermal conductivity of 150 W/(m·K), 180 W/(m·K) or 2000 W/(m·K), respectively. The selection of the material for the dielectric cover is of great importance for efficiently conducting the heat. Additionally, the good thermal conductivity of the non-conducting glue between the radiating device and the dielectric cover allows heat transfer from the radiating device to the dielectric cover. The thermal conductivity of the dielectric filling, as a contrast, is usually quite low. Hence, by applying the radar circuit package, the main path for conducting heat in the sensor system is from the radiating device, via the dielectric plate, the lead frame and the solder pins, further to the PCB and the environment.

According to another embodiment, the dielectric cover comprises no doping.

According to another embodiment, the dielectric cover comprises a slight doping concentration in the order of $10^{13}$ - $10^{15}$ atoms/cm$^3$, in particular a slight doping of around $10^{14}$ atoms/cm$^3$. This results in moderate damping within the cover and prevents or reduces the generation of undesirable surface waves.

Moreover, the selection of the material also depends on further material properties. For example, the dielectric cover may comprise diamond with a high thermal conductivity may only be implemented in very-high performance systems due to its high cost.

As a further example, similar to the radar circuit 20 comprising a single silicon chip in the substrate with a low bulk doping concentration using the modern SiGe BiCMOS (Silicon-Germanium bipolar plus CMOS) technology, the dielectric cover may comprise silicon in form of a mono-crystalline plate or a wafer without doping or with a well-defined doping concentration as described above. This allows an optimized selection of damping properties of the dielectric cover to suppress the surface waves within the package. For example, the doping concentration in the range of $10^{14}$ atoms/cm$^3$ may result in a resistivity of around 20-50 $\Omega$ cm.

According to another embodiment, the dielectric filling comprises an opening around the antenna, so that the antenna is not covered by the dielectric filling resulting in increased antenna efficiency.

In case that the radar chip and the dielectric cover both comprise silicon, there is no barrier between the silicon chip and the silicon cover due to the same relative dielectric constant, and nearly all radiation from the integrated antenna may transit into the silicon cover with a minimal loss of the radiation power. On the antenna-side of the silicon chip, opposite to the cover-side, a small part of radiation from the antenna may transit into the air and can be considered as parasitic radiation. The portion may be calculated based on the following formula:

$$ \frac{P_{air}}{P_{total}} = \frac{1}{\varepsilon_{Si}^{3/2}} $$

wherein $P_{air}$ and $P_{total}$ are the portion of the radiation into the air and the total portion of the radiation, respectively, and the $\varepsilon_{Si}$ is the relative permittivity of the silicon. Therefore, at the parasitic interface surface, only 3% of the radiation power is radiated into the air below the package due to the higher relative permittivity of silicon in comparison to that of air ($\varepsilon_{air} \cong 1$). Most of the radiation enters the silicon plate and can be radiated in the intended direction through the lens placed on top of the silicon plate.

With the opening in the dielectric filling around the antenna, the ratio of the radiation power directing towards the dielectric cover to the radiation power directing towards the dielectric filling may be enlarged, resulting in a higher measurement efficiency of the sensor comprising the radar circuit package.

According to another embodiment, the dielectric filling comprises a metallic layer, which is arranged on a surface of the dielectric filling and configured as a reflector to reflect the radar signal towards the dielectric cover. This may further enhance the ratio or the portion of the radiation power directing towards the dielectric cover and thus improve the measurement efficiency of the sensor comprising the radar circuit package. The distance of this metallic layer to the antenna should be in the range of $\lambda/2$ (half wavelength).

According to another embodiment, the radar circuit package comprises an external size of approximately 5 x 5 mm$^2$ or less. Furthermore, additionally or alternatively, the lead frame may comprise at least 10 leads, in particular 32 leads, or metal bars.

According to another embodiment, the radar circuit package may comprise a plurality of chips. This multichip package may enhance the functionality of the radar system with very compact size. The plurality of chips in package may carry multiple antennas resulting in phased array solutions and/or in MIMO systems in package.

The external size or the external shape of the radar circuit package may be similar to that of a standard QFN-package. This enables a direct implementation of the fabricated radar circuit package to the device or the system originally designed for QFN-packaged chips without significant modification and guaranties good process ability of the integrated circuit in board assembly process.

According to another embodiment, the dielectric lens is glued to the top of the dielectric cover with a non-conducting glue.

Additionally, the radar circuit package may comprise a metal around the lens for additional heat removal or heat dissipation.

According to another embodiment, the dielectric lens and the dielectric cover may be fabricated as one piece. Especially, lenses made from metamaterials can be used there because they may have a flat surface.

The radiating cover with the integrated dielectric lens may advantageously result in an increase in the radiating efficiency, especially without passing through multilayers or interface surfaces, and an increase in the bandwidth. Compared to the separated arrangement of the dielectric lens and the dielectric cover, the integrated dielectric cover with the integrated dielectric lens, which may be fabricated at a higher cost compared to the separated arrangement of the dielectric lens and the dielectric cover, can be applied for high-performance industrial and medical applications and many university research projects.

According to another embodiment, the radar circuit package may comprise more than one radar circuit arranged within the package.

According to another embodiment, the radar circuit package may comprise more than one antenna arranged within the package.

According to a second aspect, a sensor comprising a radar circuit package, which is configured to protect a radar circuit or a radar chip for effective radiation of a radar signal, is provided.

The sensor may be configured as a receiving device or an integrated radiating and receiving device.

According to another aspect, a method for fabricating a radar circuit package of a sensor, which is configured to protect a radar circuit or a radar chip for effective radiation of a radar signal, is provided. The method comprises the following steps: first, preparing a radar circuit comprising an antenna; arranging a dielectric cover on a surface of a lead frame, followed by mounting the radar circuit to the dielectric cover; then connecting the lead frame electrically to the radar circuit by means of at least one electric connection, e.g. in form of a bond-wire; finally, preparing a dielectric filling to cover the radar circuit, the at least one electric connection and the at least one part of the lead frame in order to protect the radar circuit.

According to an embodiment, the method further comprises the step of arranging a dielectric lens on top of the dielectric cover.

The method may be developed based on the standard QFN-package technology, taking advantage of the low-cost of the batch fabrication, which means, a plurality of lead frames may be arranged on a lead frame strip, which may be molded to protect the circuit packages. By cutting the molded lead frame strip into pieces, a radar circuit package may be provided.

The method for fabrication the radar circuit package may be implemented in the automated series production of the radar circuit.

These and other aspects will be apparent from and elucidated with reference to the embodiments as per the drawings described hereinafter.

Brief description of the figures

Fig. 1    shows schematically a radar circuit package.

Fig. 2    shows schematically a sectional view of a radar circuit package in accordance with an embodiment.

Fig. 3    shows schematically a bottom view of a radar circuit package in accordance with an embodiment.

Fig. 4    shows schematically a sectional view of a radar circuit package in accordance with another embodiment.

Fig. 5    shows schematically a sectional view of a radar circuit package in accordance with another embodiment.

Fig. 6    shows schematically a sectional view of a radar circuit package in accordance with another embodiment.

Fig. 7    shows schematically a flow chart illustrating a method for fabricating a radar circuit package in accordance with an embodiment.

Detailed description of embodiments

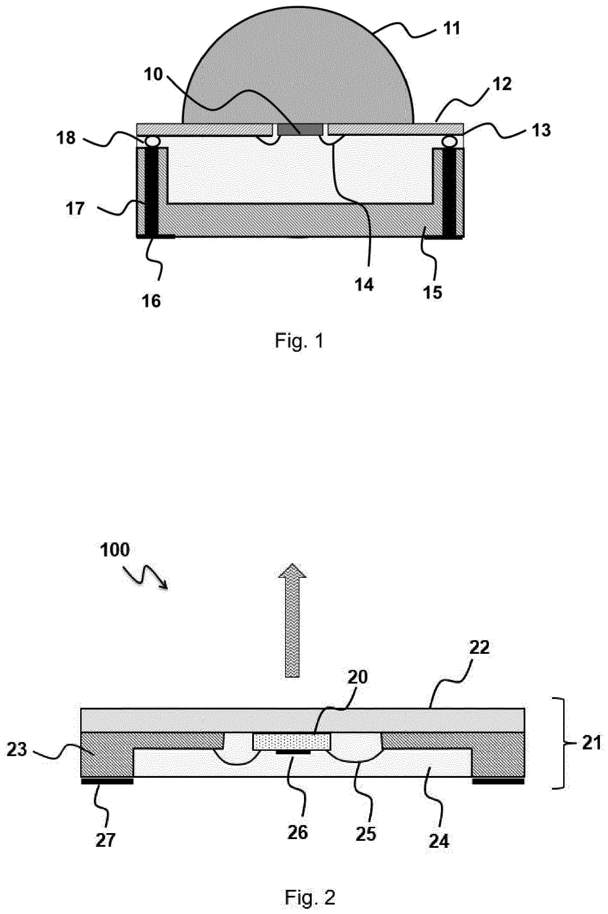

Fig. 1 shows schematically a hand-made radar circuit package, which is mainly applied in research work at universities or other scientific institutes for radar and communication application.

The radar circuit package comprises a radar circuit 10, which is mounted or glued to a silicon lens 11.

The silicon lens 11 is further mounted or glued to a first surface of a redistribution plate 12, which comprises or consists of PCB material, e.g. FR4. The redistribution plate 12 comprises conducting copper lines 13, which are arranged on a second surface of the redistribution plate 12 (opposite to the first surface) and configured to be electrically connected to the radar circuit 10 via electric connections, e.g. bond wires 14. The radar circuit package comprises further a package body 15, which is configured to support or ensemble all components or elements and to carry solder pins 16, which are configured to connect the radar circuit package to a PCB of the system (not shown). The package body 15 comprises conducting vias 17 or conducting paths 17, configured to connect the solder pins 16 to the redistribution plate 12 via stud bumps 18, which comprises or consists of gold and are configured to provide electrical connections between the vias 17 and the conducting copper lines 13. As such, the solder pins 16 are electrically connected to the radar circuit 10 by means of the vias 17, the stud bumps 18 and the bond wires 14.

The radar circuit package in Fig.1 is mostly manually packaged, e.g. by gluing the redistribution plate 12 to the silicon lens 11, by gluing the radar circuit 10 to the silicon lens 11, or by connecting or wire bonding the radar circuit 10 to the redistribution plate 12. Also, the connection between the redistribution plate 12 and the package body 15 is manually established using the glue and/or the stud bumps 18. The hand-made packaging process may impede the automated production of the radar circuit package.

Fig. 2 shows schematically a sectional view of a radar circuit package 21 of a sensor 100 in accordance with an embodiment.

The circuit package 21 of a device 100, such as a transmitter, a receiver, a communication device or a sensor, in Fig. 2 comprises an integrated circuit or a radar circuit 20 with an integrated antenna 26, configured to transmit or receive a radiating signal operating at a high frequency (GHz to THz). The simple structure of the radar circuit package 21 enables automated fabrication in series production. The radar circuit package 21 is of high performance despite of its low-cost solution for high-frequency systems.

The radar circuit package 21 comprises a dielectric cover 22, a lead frame 23, a dielectric filling 24 and at least one electric connection 25. The radar circuit 20 with the integrated antenna 26 is mounted or glued to the dielectric cover 22 on a first surface by means of a non-conducting glue, which has a good thermal conductivity. The dielectric cover 22 is transparent for the applied radiation. On the first surface, the dielectric cover 22 is further mounted to the lead frame 23, which comprises or consists of copper for optimized electrical conductivity and thermal conductivity and is electrically connected to the radar circuit 20 by means of the at least one electric connection 25. The electric connection may be in form of a bond wire, which is connected or bonded to the lead frame 23 at one end and to an electrical pad of the radar circuit 20 at the other end. On the side of lead frame 23 opposite to the dielectric cover 22, solder pins 27 are arranged or formed and configured to electrically connect the radar circuit package 21 to the PCB of the sensor 100.

The dielectric filling 24 covers the radar circuit 20, the at least one electric connection 25, and the at least one part of the lead frame 23. The dielectric filling may comprise or consist of a resin or an epoxy resin, which is configured to stabilize all of the components such as the radar circuit 20, the bond wires 25 and the lead frame 23. The dielectric filling 24 may comprise a metallic layer (not shown), which is configured as a reflector to reflect the radar signal towards the dielectric cover 22.

With good thermal conductivity of the dielectric cover 22, the thermal energy or the heat generated in the radiating device or the radar circuit 20 is able to be conducted or dissipated to the PCB via the dielectric cover 22, the lead frame 23 and the solder pins 27. Due to the low thermal conductivity of the dielectric filling 24, there is almost no path for conducting the thermal energy from the radar circuit 20 to the dielectric filling 24.

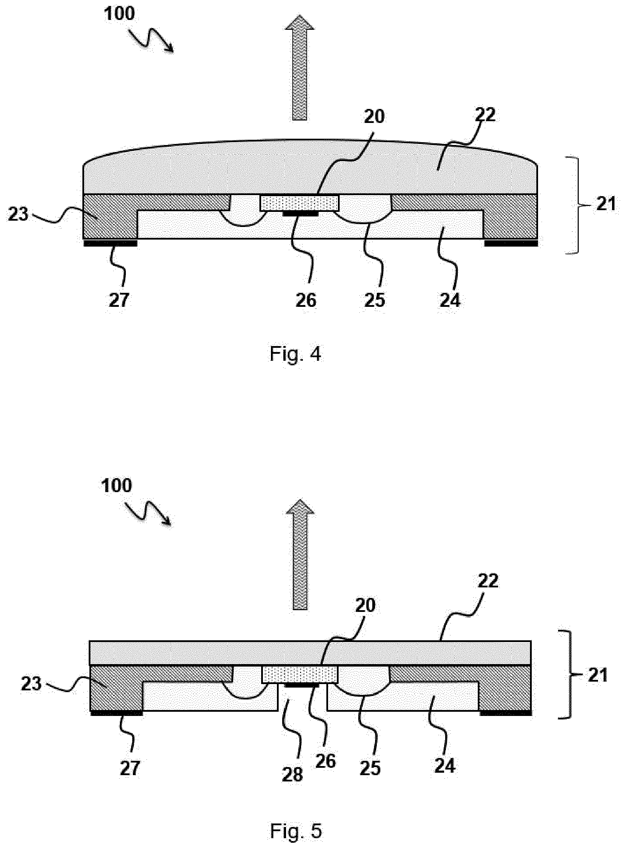

The dielectric cover 22 in Fig. 2 is a dielectric plate. Alternatively, the dielectric cover 22 may be an integrated piece of a dielectric plate and a lens, as shown in Fig. 4.

For high antenna-efficiency and for a wide bandwidth of the operating signal, the radiation of the radar circuit 20 may be directed through the dielectric cover 22 with the integrated dielectric lens, which is configured to focus the radiation from the radar circuit 26 to the environment or air above the dielectric cover 22. A conventional lens has usually a curved shape in cross-section. By using meta-materials for the lens, a flat shape can be used for the lens that can be handled more easily in series production.

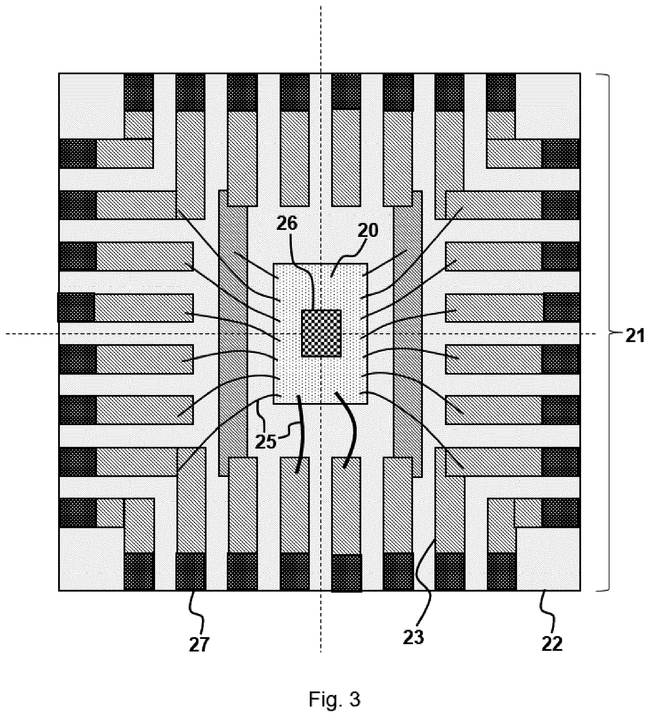

Fig.3 shows schematically a bottom view of a radar circuit package 21, which has an external size of 5 x 5 mm$^2$ and 32 leads, similar to that of a standard 5 x 5 mm$^2$ QFN-package. As shown in Fig. 3, the radar circuit package 21 comprises the components in Fig. 2, such as the radar circuit 20 with the integrated antenna 26, the dielectric cover 22, the lead frame 23, and the at least one electric connection 25, which is configured to connect the radar circuit 20 to one of the leads of the lead frame 23. On the bottom side of the lead frame 23, solder pins 27 of the package 21 are formed. The dielectric filling 24 in Fig. 2, which is configured to cover and stabilize the radar circuit 20, the electric connections 25 and the at least one part of the lead frame 23, is not shown in Fig.3 for better visibility.

The lead frame 23 is configured to conduct the electrical signal by means of the leads or the metal-bars of the lead frame 23 from the radar circuit 20 to the solder pins 27. The leads of the lead frame 23 are designed with a width and/or a space of around 200 $\mu$m. Furthermore, the leads can be fabricated using standard methods for lead frame manufacturing. The thickness of the lead frame 23 is around 300 $\mu$m in the region of the solder pins 27 and 150 $\mu$m in the other regions.

Fig. 5 shows schematically a sectional view of a radar circuit package 21 in accordance with another embodiment. Compared to the radar circuit package 21 in Fig. 2, the dielectric filling 24 of the radar circuit package 21 in Fig. 5 comprises an opening 28 around the antenna 26.

According to the above described formula, with the opening 28 in the dielectric filling 24, the ratio of the radiation power directing from the antenna 26 towards the dielectric cover 22 to the radiation power directing from the antenna 26 towards the dielectric filling 24 or towards the PCB may be enlarged due to the higher relative permittivity of the dielectric cover 22, e.g. comprising silicon, in comparison to that of the air, resulting in a higher measurement efficiency compared to that with a complete filling without any opening.

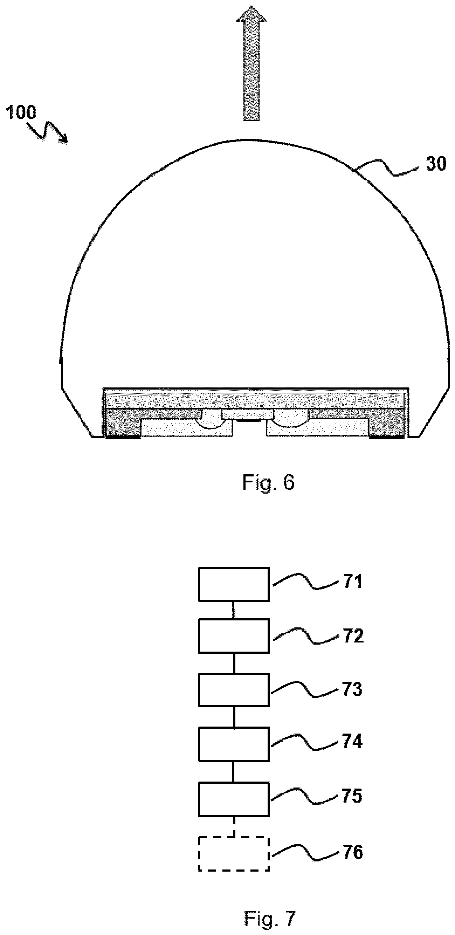

In Fig. 6, the radar circuit package 21 comprises a dielectric lens 30, which is separateble from and in addition to a dielectric plate as the cover of the radar circuit package 21. With the lens 30, which is mounted or glued directly on top of the dielectric cover 22 using a non-conducting glue, the radiation may transit into the lens material. The lens 30 may comprise or consist of silicon for a high performance, as there is almost no barrier and no reflection between the dielectric cover 22 and the lens 30. The lens 30 is configured to focus the radiation and direct the radiation to the top direction as indicated in Fig.5. The lens 30 is formed as a hemispherical lens. Alternatively, the shape and the size of the lens 30 is flexible for various approaches for forming the radar beam. To optimize the radiation transition from the lens 30 to the environment or air, the lens may further comprise a matching layer at the top or at the interface surface.

Fig. 7 shows schematically a flow chart illustrating a method for fabricating a radar circuit package 21, which is configured to protect a radar circuit 20 or a radar chip and for effective radiation of a radar signal.

The method starts at step 71 where a radar circuit 20 with an integrated antenna 26 may be provided. At the subsequent step 72, a dielectric cover 22 is arranged on a surface of a lead frame 23 by gluing with non-conducting glue.

At a further step 73, the radar circuits 20 is mounted to the dielectric cover 22, followed by the step 74, at which the lead frame is electrically connected to the radar circuit by means of at least one electric connection in form of a bond-wire; finally, at step 75, a dielectric filling is provided to cover the radar circuit, the at least one electric connection and the at least one part of the lead frame in order to protect the radar circuit and the bond-wires.

The method further comprises the step 76 of arranging a dielectric lens on top of the dielectric cover. Alternatively, the step 76 may be eliminated when the dielectric cover 22 and the lens are fabricated as one piece as shown in Fig. 4.

The method may be developed based on the standard QFN-package technology, taking advantage of the low-cost of batch fabrication, which means, a plurality of lead frames may be arranged on a lead frame strip, which may be molded to protect the circuit packages. By cutting the molded lead frame strip into pieces, many radar circuit packages may be provided during few manufacturing steps.

The method for fabrication the radar circuit package may be implemented in the automated series production of the radar circuit.

In addition, it is pointed out that the terms "comprising" and "having" do not exclude any other elements or steps and "a" or "one" do not exclude a plurality. It should further be noted that features or steps which have been described with reference to one of the above embodiments may also be used in combination with other features or steps of other above-described embodiments. Reference numerals in the claims should not be interpreted as limiting.

**Claims**

1. A radar circuit package (21) for protecting a radar circuit (20) and for effective radiation of a radar signal, comprising:

   a radar circuit (20) comprising an antenna (26);
   a dielectric cover (22), on which the radar circuit (20) is mounted, configured to protect the radar circuit (20);
   a lead frame (23), configured to be electronically connected to the radar circuit (20) by means of at least one electric connection (25); and
   a dielectric filling (24), configured to cover the radar circuit (20), the at least one electric connection (25) and at least one part of the lead frame (23), and configured to protect the radar circuit (20);
   wherein the dielectric cover (22) is configured to be transparent for the radiation.

2. The radar circuit package (21) according to claim 1, further comprising a dielectric lens (30), which is arranged on top of the dielectric cover (22).

3. The radar circuit package (21) according to one of the preceding claims,
   wherein the dielectric cover (22) is configured to distribute heat generated by the radar circuit (20) to the lead frame (23), which, in turn, is configured to distribute the heat to solder pins (27).

4. The radar circuit package (21) according to one of the preceding claims,

   wherein the dielectric cover (22) comprises silicon, aluminium nitride (AlN) or diamond.

5. The radar circuit package (21) according to one of the preceding claims,
   wherein the dielectric cover (22) comprises monocrystalline silicon.

6. The radar circuit package (21) according to one of the preceding claims,
   wherein the dielectric cover (22) comprises no doping.

7. The radar circuit package (21) according to one of the preceding claims,
   wherein the dielectric cover (22) comprises a slight doping concentration in the order of $10^{13} - 10^{15}$ atoms/cm$^3$.

8. The radar circuit package (21) according to one of the preceding claims,
   wherein the dielectric filling (24) comprises an opening (30) around the antenna (26), so that the antenna (26) is not covered by the dielectric filling (24).

9. The radar circuit package (21) according to one of the preceding claims,
   wherein the dielectric filling (24) comprises a metallic layer, which is arranged on a surface of the dielectric filling and configured as a reflector to reflect the radar signal towards the dielectric cover (22).

10. The radar circuit package (21) according to one of the preceding claims,
    wherein the radar circuit package (21) comprises an external size of approximately $5 \times 5$ mm$^2$ or less ; and wherein the lead frame (23) comprises at least 10 leads, in particular 32 leads.

11. The radar circuit package (21) according to one of claims 2 to 10,
    wherein the dielectric lens (30) is glued to the top of the dielectric cover (22) with a non-conducting glue.

12. The radar circuit package (21) according to one of claims 2 to 11,
    wherein the dielectric lens (30) and the dielectric cover (22) are fabricated as one piece.

13. The radar circuit package (21) according to one of the preceding claims,
    wherein the radar circuit package (21) comprises more than one radar circuit (20) arranged within the package.

14. The radar circuit package (21) according to one of the preceding claims,
    wherein the radar circuit package (21) comprises more than one antenna (26) arranged within the package.

15. A sensor (100), comprising a radar circuit package (21) according to one of claims 1 to 12.

16. A method for fabricating a radar circuit package (21), which is configured to protect a radar circuit (20) for effective radiation of a radar signal, the method comprising the steps of:

preparing (71) a radar circuit (20) comprising an antenna (26);
arranging (72) a dielectric cover (22) on a surface of a lead frame (23);
mounting (73) the radar circuit (20) to the dielectric cover (22);
connecting (74) the lead frame (23) electronically to the radar circuit (20) by means of at least one electric connection (25); and
preparing (75) a dielectric filling (24) to cover the radar circuit (20), the at least one electric connection (25) and the lead frame (23) and to protect the radar circuit (20).

17. The method according to claim 16, further comprising:
arranging (76) a dielectric lens (30) on top of the dielectric cover (22).

**Amended claims in accordance with Rule 137(2) EPC.**

1. A radar circuit package (21) for protecting a radar circuit (20) and for effective radiation of a radar signal, comprising:

a radar circuit (20) comprising an antenna (26);
a dielectric cover (22), on which the radar circuit (20) is mounted, configured to protect the radar circuit (20);
a lead frame (23), to which the dielectric cover (22) is mounted and which is electronically connected to the radar circuit (20) by means of at least one electric connection (25); and
a dielectric filling (24), configured to cover the radar circuit (20), the at least one electric connection (25) and at least one part of the lead frame (23), and configured to protect the radar circuit (20);
wherein the dielectric cover (22) is configured to be transparent for the radiation;
wherein the antenna (26) is arranged on a side of the radar circuit (20) opposite to the dielectric cover (22).

2. The radar circuit package (21) according to claim 1,

further comprising a dielectric lens (30), which is arranged on top of the dielectric cover (22).

3. The radar circuit package (21) according to claim 1 or 2,
wherein the dielectric cover (22) is configured to distribute heat generated by the radar circuit (20) to the lead frame (23), which, in turn, is configured to distribute the heat to solder pins (27).

4. The radar circuit package (21) according to one of the preceding claims,
wherein the dielectric cover (22) comprises silicon, aluminium nitride (AIN) or diamond.

5. The radar circuit package (21) according to one of the preceding claims,
wherein the dielectric cover (22) comprises mono-crystalline silicon.

6. The radar circuit package (21) according to one of the preceding claims,
wherein the dielectric cover (22) comprises a slight doping concentration in the order of $10^{13}$ - $10^{15}$ atoms/cm$^3$.

7. The radar circuit package (21) according to one of the preceding claims,
wherein the dielectric filling (24) comprises an opening (30) around the antenna (26), so that the antenna (26) is not covered by the dielectric filling (24).

8. The radar circuit package (21) according to one of the preceding claims,
wherein the dielectric filling (24) comprises a metallic layer, which is arranged on a surface of the dielectric filling and configured as a reflector to reflect the radar signal towards the dielectric cover (22).

9. The radar circuit package (21) according to one of the preceding claims,
wherein the radar circuit package (21) comprises an external size of approximately 5 x 5 mm$^2$ or less ; and wherein the lead frame (23) comprises at least 10 leads, in particular 32 leads.

10. The radar circuit package (21) according to one of claims 2 to 9,
wherein the dielectric lens (30) is glued to the top of the dielectric cover (22) with a non-conducting glue.

11. The radar circuit package (21) according to one of the preceding claims,
wherein the radar circuit package (21) comprises more than one radar circuit (20) arranged within the package.

12. The radar circuit package (21) according to one of the preceding claims,
wherein the radar circuit package (21) comprises more than one antenna (26) arranged within the package.

13. A sensor (100), comprising a radar circuit package (21) according to one of claims 1 to 11.

14. A method for fabricating a radar circuit package (21), which is configured to protect a radar circuit (20) for effective radiation of a radar signal, the method comprising the steps of:

preparing (71) a radar circuit (20) comprising an antenna (26);
arranging (72) a dielectric cover (22) on a surface of a lead frame (23);
mounting (73) the radar circuit (20) to the dielectric cover (22) by arranging the antenna (26) on a side of the radar circuit (20) opposite to the dielectric cover (22);
mounting the dielectric cover (22) to the lead frame (23) and connecting (74) the lead frame (23) electronically to the radar circuit (20) by means of at least one electric connection (25); and
preparing (75) a dielectric filling (24) to cover the radar circuit (20), the at least one electric connection (25) and the lead frame (23) and to protect the radar circuit (20);
wherein the dielectric cover (22) is configured to be transparent for the radiation.

15. The method according to claim 16, further comprising:
arranging (76) a dielectric lens (30) on top of the dielectric cover (22).

Fig. 1

Fig. 2

Fig. 3

100

20 22

23

27 26 25 24

21

Fig. 4

100

20 22

23

27 28 26 25 24

21

Fig. 5

Fig. 6

Fig. 7

Europäisches
Patentamt

European
Patent Office

Office européen
des brevets

# EUROPEAN SEARCH REPORT

Application Number

EP 19 16 3801

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | BENJAMIN GOETTEL ET AL: "Packaging Solution for a Millimeter-Wave System-on-Chip Radar", IEEE TRANSACTIONS ON COMPONENTS, PACKAGING AND MANUFACTURING TECHNOLOGY, vol. 8, no. 1, 1 January 2018 (2018-01-01), pages 73-81, XP055604975, USA ISSN: 2156-3950, DOI: 10.1109/TCPMT.2017.2758725 | 1-5, 7-11, 13-17 | INV. G01S7/02 H01Q1/40 H01Q23/00 H01L23/00 |
| Y | * page 74 - page 78 * <br> * figures 2,6,7,9,11 * | 6,12 | |
| Y | AYDIN BABAKHANI ET AL: "A 77-GHz Phased-Array Transceiver With On-Chip Antennas in Silicon: Receiver and Antennas", IEEE JOURNAL OF SOLID-STATE CIRCUITS, IEEE SERVICE CENTER, PISCATAWAY, NJ, USA, vol. 41, no. 12, 1 December 2006 (2006-12-01), pages 2795-2806, XP011150711, ISSN: 0018-9200, DOI: 10.1109/JSSC.2006.884811 | 6 | |
| A | * page 2795 * <br> * figure 11 * | 1,2,4,5, 7-9 | TECHNICAL FIELDS SEARCHED (IPC) <br> G01S H01Q H01L |
| Y | EP 1 357 395 A1 (HITACHI LTD [JP]) 29 October 2003 (2003-10-29) | 12 | |
| A | * paragraph [0007] * <br> * paragraph [0010] * <br> * paragraph [0012] * <br> * paragraph [0031] * | 1,2,11 | |

The present search report has been drawn up for all claims

| Place of search | Date of completion of the search | Examiner |
|---|---|---|
| Munich | 17 July 2019 | Rodríguez González |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 19 16 3801

This annex lists the patent family members relating to the patent documents cited in the above-mentioned European search report.
The members are as contained in the European Patent Office EDP file on
The European Patent Office is in no way liable for these particulars which are merely given for the purpose of information.

17-07-2019

| Patent document cited in search report | | Publication date | Patent family member(s) | | Publication date |
|---|---|---|---|---|---|
| EP 1357395 | A1 | 29-10-2003 | DE | 60221353 T2 | 17-04-2008 |
| | | | EP | 1357395 A1 | 29-10-2003 |
| | | | JP | 4523223 B2 | 11-08-2010 |
| | | | JP | 2003315438 A | 06-11-2003 |
| | | | US | 2003201930 A1 | 30-10-2003 |
| | | | US | 2004160357 A1 | 19-08-2004 |
| | | | US | 2005093738 A1 | 05-05-2005 |

EPO FORM P0459

For more details about this annex : see Official Journal of the European Patent Office, No. 12/82